(19) Europäisches Patentamt

European Patent Office

Office européen des brevets

(11) **EP 1 039 597 B1**

(12) **EUROPÄISCHE PATENTSCHRIFT**

(45) Veröffentlichungstag und Bekanntmachung des Hinweises auf die Patenterteilung:
**21.06.2006 Patentblatt 2006/25**

(51) Int Cl.:
*H01S 5/068* (2006.01)    *H05B 33/08* (2006.01)
*H01S 5/042* (2006.01)

(21) Anmeldenummer: **00105565.6**

(22) Anmeldetag: **16.03.2000**

(54) **Verfahren zur Stabilisierung der optischen Ausgangsleistung von Leuchtdioden und Laserdioden**

Method for stabilising the optical output of light emitting diodes and laserdiodes

Méthode de stabilisation de la puissance optique des diodes à l'emission de lumière et des lasers à diodes

(84) Benannte Vertragsstaaten:
**DE GB IT**

(30) Priorität: **19.03.1999 DE 19912463**

(43) Veröffentlichungstag der Anmeldung:
**27.09.2000 Patentblatt 2000/39**

(73) Patentinhaber: **Sensor Line Gesellschaft für optoelektronische Sensoren mbH
86529 Schrobenhausen (DE)**

(72) Erfinder:
• **Plamper, Jörg
86529 Schrobenhausen (DE)**
• **Engl, Josef
85296 Rohrbach (DE)**

(74) Vertreter: **Haft, Uwe Michael
Patentanwälte
Haft, von Puttkamer
Berngruber, Czybulka
Franziskanerstrasse 38
81669 München (DE)**

(56) Entgegenhaltungen:
**DE-A- 3 832 109        DE-A- 19 729 690
US-A- 4 639 924**

• **ALBANESE A: "An automatic bias control (ABC) circuit for injection lasers" BELL SYSTEM TECHNICAL JOURNAL, AT AND T, SHORT HILLS, NY, US, Bd. 57, Nr. 5, Mai 1978 (1978-05), Seiten 1533-1544, XP002155241 ISSN: 0005-8580**
• **PATENT ABSTRACTS OF JAPAN vol. 004, no. 028 (E-001), 8. März 1980 (1980-03-08) & JP 55 001147 A (NEC CORP), 7. Januar 1980 (1980-01-07)**
• **PATENT ABSTRACTS OF JAPAN vol. 007, no. 099 (E-172), 27. April 1983 (1983-04-27) & JP 58 021886 A (NIPPON DENKI KK;OTHERS: 02), 8. Februar 1983 (1983-02-08)**

EP 1 039 597 B1

**Beschreibung**

Leuchtdioden und Laserdioden haben als Lichtquellen in der Meßtechnik und für Anzeigezwecke aufgrund ihres geringen Energiebedarfs, ihrer kleinen Abmessungen, ihrer Robustheit, ihrer guten Modulierbarkeit und nicht zuletzt aufgrund ihres günstigen Preises erhebliche Bedeutung erlangt. Für bestimmte Anwendungen ist es nachteilig, daß die optische Ausgangsleistung dieser Lichtquellen von ihrer Temperatur abhängt, sie nimmt bei Erwärmung ab. In der Meßtechnik sind hiervon alle Anwendungen betroffen, bei denen eine Größe über das Transmissionsvermögen irgendeiner optischen Übertragungsstrecke erfaßt wird. Beispiele hierfür sind Verfahren zur Messung der Trübung oder Farbe von Festkörpern, Flüssigkeiten und Gasen, vor allem aber auch faseroptische Verfahren zur Messung der unterschiedlichsten Größen, bei denen eine Lichtleitfaser unter dem Einfluß der Meßgröße ihre optischen Eigenschaften ändert. Sogar bei Anwendungen, die Leuchtdioden nur zu Anzeigezwecken nutzen kann die Erfüllung von Kundenspezifikationen oder gar gesetzlichen Vorschriften besondere Maßnahmen zum Ausgleich des Einflusses von Temperaturänderungen nötig machen. Bei Verkehrsampeln erlauben Leuchtdioden z.B. signifikante Energieeinsparungen, doch ist der Temperaturgang mancher hierfür geeigneter Typen und der Betriebstemperaturbereich so groß, daß ohne eine besondere Temperaturkompensation die amtlich vorgeschriebene Helligkeit nicht eingehalten werden könnte.

Um die optische Ausgangsleistung von Leucht- und Laserdioden konstant zu halten sind im Wesentlichen zwei Vorgehensweisen gebräuchlich. Man kann sie zunächst einmal regeln. Die hierdurch erzielten Ergebnisse sind jedoch nicht so befriedigend wie intuitiv zu erwarten wäre, weil die zur Regelung erforderliche Helligkeitsmessung unter besonders ungünstigen Bedingungen stattfinden muß. Zuerst muß hierfür ein gewisser Anteil des emittierten Lichts quasi abgezweigt und darüber hinaus konstant gehalten werden, worin bereits die erste Fehlerquelle besteht. Da dieses Licht später nicht mehr zur Verfügung steht, bemüht man sich naturgemäß, mit möglichst wenig davon auszukommen. Dies geht mit einer Verringerung der relativen Meßgenauigkeit einher. Außerdem wird das geregelte Licht oft in einer u.U. beleuchteten Umgebung benötigt, aus der natürlich Fremdlicht auf den Meßempfänger gelangen kann. Der Einfluß von solchem Fremdlicht ist umso größer, je kleiner der zwecks Regelung abgezweigte Anteil des emittierten Lichts ist. Zu alledem besitzt der Meßempfänger meist ebenfalls eine Temperaturabhängigkeit und wird oft auch noch durch die an der Lichtquelle auftretende Verlustleistung erwärmt. Das gleiche gilt für die Geometrie der Übertragungsstrecke zwischen Lichtquelle und Meßempfänger.

Bessere Ergebnisse kann man erwarten, wenn die Temperatur der Leucht- oder Laserdiode konstantgehalten wird. Zu diesem Zweck wird das Bauteil bzw. der Chip zusammen mit einem Temperatursensor auf einem thermoelektrischen Kühlelement montiert, und die von dem Temperatursensor gemessene Temperatur wird über einen Regler auf einem konstant niedrigen Wert gehalten, was gleichzeitig die Lichtausbeute steigert. Man verläßt sich dabei darauf, daß der thermische Einfluß des Kühlelements auf Lichtquelle und Temperatursensor groß gegen Einflüsse aus der Umgebung ist, sodaß aus einer konstanten Temperatur des Sensors auf eine konstante Temperatur der Lichtquelle geschlossen werden kann. Da das in recht guter Näherung gegeben ist, wird diese Art der Lichtstabilisierung für Meßzwecke meist bevorzugt. Sie ist aber apparativ aufwendig. Lichtquelle, Kühlelement und Temperatursensor müssen nicht nur bezahlt, sondern auch - oft mit einer zusätzlichen s.g. Monitor-Photodiode, die zu justieren ist - zusammengebaut werden Das Kühlelement braucht einen großen Strom bei kleiner Spannung, den übliche Netzteile nicht ohne weiteres liefern, und es erzeugt viel Abwärme, die abgeführt werden muß. Damm ist diese Vorgehensweise ziemlich teuer.

Eine dritte Methode besteht darin, auf das Kühlelement zu verzichten, mit einem Temperaturfühler die Temperatur der Lichtquelle oder auch die Umgebungstemperatur zu erfassen, und das Licht mit Hilfe dieses Meßwerts zu steuern. Da Leucht- oder Laserdiodenchips aber recht klein sind, ist es schwierig, eine gute thermische Kopplung mit dem Temperatursensor zu erreichen, sodaß dessen Temperatur und damit der Meßwert nicht mehr uneingeschränkt ein Maß für die Temperatur der Lichtquelle ist. Erst recht gilt dies natürlich bei einer Messung der Umgebungstemperatur. Damm kann diese Art der Stabilisierung nicht besonders genau sein. Sie ist aber nicht sehr aufwendig, kann preisgünstig realisiert werden und stellt daher z.B. für Anzeigezwecke eine praktikable Lösung dar.

Im Rahmen der US 4,639,924 ist ein System zur Stabilisierung der optischen Ausgangsleistung einer Laserdiode beschrieben, bei der zur Stabilisierung der Lichtleistung ein Thermistor benötigt wird. Hierbei ist die Durchlassspannung der Laserdiode eine Stellgröße, durch deren Variation ein Spannungsabfall an dem temperturabhängigen Widerstandsnetzwerk, welches den Thermisto umfasst, konstant gehalten wird.

Des weiteren ist in der Veröffentlichung von Albanese A: "An automatic bias control (ABC) circuit for injection lasers" BELL SYSTEMS TECHNICAL JOURNAL, AT AND T, SHORT HILLS, NY, US, Bd. 57, Nr. 5, Mai 1978 (1978-05), Seiten 1533-1544, XP002155241 ein Schaltkreis und ein Verfahren zur Temperaturanpassung des Bias-Stroms beschrieben, wodurch die Laserdiode bei jeder Temperatur in einem Zustand gehalten wird, bei dem sie gerade noch ausgeschaltet ist.

Im Zusammenhang mit der Temperaturstabilisierung von Leuchtdioden oder Laserdioden muß unbedingt der Aspekt der Modulierbarkeit beachtet werden. Diese Lichtquellen lassen sich in extrem kurzer Zeit ein- und ausschalten. Sie haben darum nicht nur im Fernmeldewesen sondern auch in der Meßtechnik wesentliche Vorteile vor z.B. Glühlampen. Letztere müssen bei bestimmten Messungen mit einem mechanischen Verschluß, einem s.g. Chopper versehen werden, um das Licht periodisch abschatten und damit den Einfluß von Umgebungslicht kompensieren zu können. Bei Leucht- und Laserdioden läßt sich dieser Effekt viel einfacher und auch mit viel höheren Frequenzen durch schlichtes Unterbrechen des Stromes erzielen. Für ein Verfahren zu ihrer Stabilisierung ist es deshalb ein wesentliches Qualitätsmerkmal, wie schnell die ausgesandte Lichtleistung einen stabilen Wert annimmt. Alle Verfahren, bei denen sich nach dem Einschalten des Lichts zunächst irgendein Meßwert ändert, anhand dessen die Lichtleistung korrigiert wird, haben hier signifikante Nachteile. Das trifft sowohl bei der Regelung der Lichtleistung als auch bei der Erfassung der Chiptemperatur mit einem Sensor zu. Da eine Erfassung der Umgebungstemperatur keine für Meßzwecke ausreichende Genauigkeit ermöglicht, kann eine stabilisierte Lichtleistung nur bei Verwendung eines thermoelektrischen Kühlelements auch gut moduliert werden.

Nicht zuletzt aus Gründen guter Modulierbarkeit wurde bereits mehrfach angedacht, die Leuchtdiode oder Laserdiode selbst als Temperaturfühler zu benutzen. Halbleiterdioden sind hierfür schließlich sehr gut geeignet; ihre Durchlaßspannung ändert sich bei konstantem Strom über der Temperatur mit durchaus brauchbarer Linearität. Ein von der Diode selbst gewonnener Meßwert würde genau die Temperatur angeben, die Einfluß auf die Lichtleistung nimmt und daher bei einer Stabilisierung zu berücksichtigen ist. Leider muß eine Stabilisierung unter Berücksichtigung einer sich ändernden Temperatur aber durch eine Änderung des Diodenstroms erfolgen, der zur Temperaturmessung gerade nicht geändert werden sollte. Ein Temperaturmeßwert läßt sich hier nicht mehr aus der Durchlaßspannung allein ableiten, sondern ist auch noch vom gerade fließenden Strom abhängig. Die Ermittlung eines Meßwerts als Funktion nicht nur einer sondern zweier Variablen, m.a.W. der Übergang von einer Kennlinie zu einer "Kennfläche" ist aber ein Weg, der in der Meßtechnik nur äußerst ungern beschritten wird.

Es ist aber nicht unbedingt erforderlich, die Temperatur einer Leucht- oder Laserdiode explizit zu kennen, um ihren Einfluß kompensieren zu können. Man erahnt das bereits bei der Überlegung, daß dazu für jede Temperatur ein ganz bestimmter Strom erforderlich ist, für den sich über die bei der betreffenden Temperatur gültige Diodenkennlinie ein ganz bestimmter Wert für die Durchlaßspannung ergibt. Man erhält also für jede Temperatur einen Punkt im Strom-Spannungsdiagramm, an dem die Lichtleistung dem geforderten Wert entspricht. Für einen Temperaturbereich wird daraus eine Linie. Nicht ohne weiteres kann darauf geschlossen werden, daß eine Kombination aus Strom und Durchlaßspannung, die auf dieser Linie liegt, zwangsläufig zur geforderten Lichtleistung führt. Das hängt davon ab, ob die betreffende Kombination für die Temperatur eindeutig ist oder ob sie sich auch bei einer anderen Temperatur ergeben kann. Gelingt es, eine Linie konstanter Lichtleistung zu ermitteln, deren Punkte alle eindeutig für die Temperatur sind und eine elektronische Schaltung zu realisieren, die die Kombination aus Strom und Durchlaßspannung stabil auf dieser Linie hält, läßt sich dadurch die Lichtleistung über der Temperatur stabilisieren, ohne eine dieser beiden Größen zu messen.

Die Aufgabe des hier beschriebenen Verfahrens ist es, eine Leuchtdiode oder Laserdiode so zu beschalten, daß die temperaturbedingte Änderung ihres elektrischen Verhaltens zu einer Temperaturunabhängigkeit ihrer optischen Ausgangsleistung führt.

Zur Charakterisierung des elektrischen und optischen Verhaltens von Leucht- oder Laserdioden als Funktion der Temperatur werden in manchen Datenblättern zwei Kennlinienfelder angegeben, von denen z.B. das eine die Durchlaßspannung und das andere die optische Ausgangsleistung jeweils als Funktion des Stromes mit der Temperatur als Parameter zeigt. Theoretisch können solchen Diagrammen alle Informationen entnommen werden, die zur Stabilisierung der betreffenden Bauteile erforderlich sind. Für die Praxis sind diese Angaben allerdings nicht genau genug. Das liegt nicht nur in der meist groben Darstellung begründet, sondern auch darin, daß bei der Messung einige besondere Feinheiten beachtet werden müssen. Es ist z.B. durchaus nicht ratsam, diese Messungen mit Gleichstrom in einem Temperaturschrank durchzuführen, wie es der gängigen Vorgehensweise entsprechen würde. Erstens entspricht die hier gemessene Temperatur nicht der Temperatur des Diodenchips, deren Wert zwar uninteressant ist, auf die es aber doch ankommt. Die Messungen von Durchlaßspannung und Lichtleistung müßten also streng gleichzeitig durchgeführt werden, um sicherzustellen, daß sie bei der gleichen Temperatur erfolgen. Zweitens wird in einem Temperaturschrank nicht nur die Lichtquelle, sondern auch der optische Meßaufbau temperiert. Letzteren temperaturunabhängig zu gestalten stellt aber wieder ein ganz besonderes Problem dar.

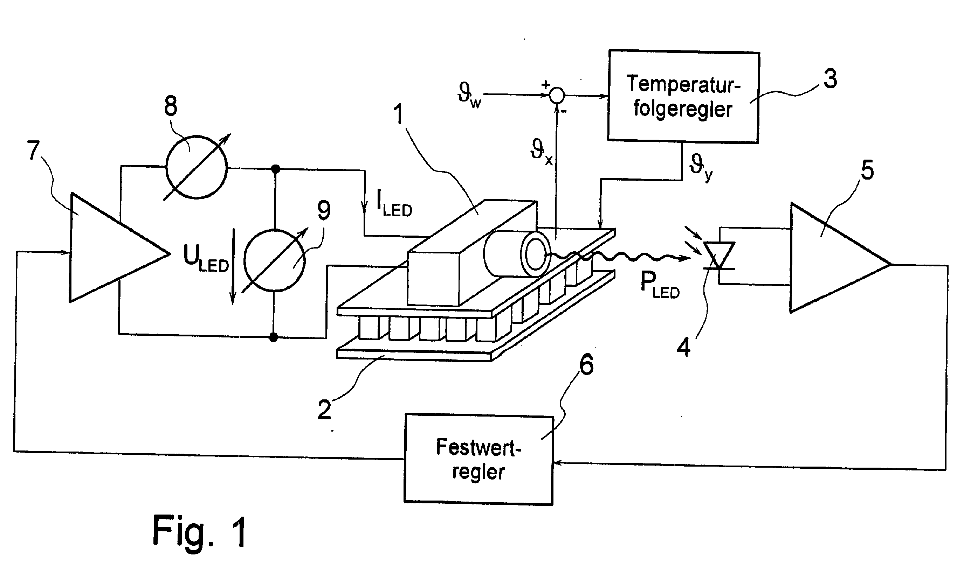

Fig. 1 zeigt einen Meßaufbau, mit dem das Temperaturverhalten einer Leuchtdiode oder Laserdiode zum Zweck ihrer Stabilisierung ohne grobe Fehler ermittelt werden kann. Die Diode (1) ist hier in einem besonderen Gehäuse zur Ankopplung eines Lichtleitersteckers dargestellt. Für Bauteile, die nicht schon in einem solchen Gehäuse vorliegen, ist eine möglichst metallische Aufnahme vorzusehen, durch die sie mit gutem Wärmekontakt auf einem thermoelektrischen Kühlelement (2) montiert werden können. Die Temperatur dieses Kühlelements (Peltierelement), mit dem bekanntlich auch geheizt werden kann, wird mit Hilfe eines Temperaturfolgereglers (3) mit möglichst konstanter Geschwindigkeit variiert, wofür natürlich auf dem Kühlelement auch noch ein hier nicht eingezeichneter Temperatursensor zu montieren ist.

Die optische Ausgangsleistung der Leuchtdiode oder Laserdiode (1) $P_{LED}$ wird mit einem thermisch isoliert montierten Photodetektor (4) gemessen. Es ist nicht ratsam, hierbei eine Lichtleitfaser zu verwenden, denn deren senderseitige Ankopplung würde ebenfalls temperiert und somit ihren eigenen Temperatureffekt in das Meßergebnis einbringen. Stattdessen schirmt man Fremdlicht lieber mit einem geeigneten Tubus ab oder führt die Messung von vornherein im Dunkeln durch.

Über einen Meßverstärker (5) einen Festwertregler (6) und ein Stellglied (7) wird die optische Ausgangsleistung $P_{LED}$ durch Einprägen eines Stroms $I_{LED}$ konstant gehalten. Der Sollwert für den Festwertregler (6) muß natürlich ebenfalls variabel sein, um Messungen bei verschiedenen

Lichtleistungen zu ermöglichen; er wird aber während eines Meßvorgangs nicht verändert.

Der Strom $I_{LED}$ als Stellgröße und die sich daraus ergebende Durchlaßspannung $U_{LED}$ werden nun mit geeigneten Meßeinrichtungen (8) und (9) möglichst gleichzeitig erfaßt und aufgezeichnet. Es ist zweckmäßig, hierfür und auch zur Sollwertvorgabe für den

Temperaturfolgeregler einen Tischrechner mit einer geeigneten Analog/Digital- bzw.

Digital/Analog-Schnittstelle einzusetzen. Dadurch wird nicht nur die Meßdatenerfassung beschleunigt, sondern auch ein Maximum an Reproduzierbarkeit sichergestellt. Die Temperatur wird nicht erfaßt; es ist nur sicherzustellen, daß sie in einem ausreichend großen Bereich variiert wird, der in etwa dem vorgesehenen Einsatztemperaturbereich entsprechen sollte.

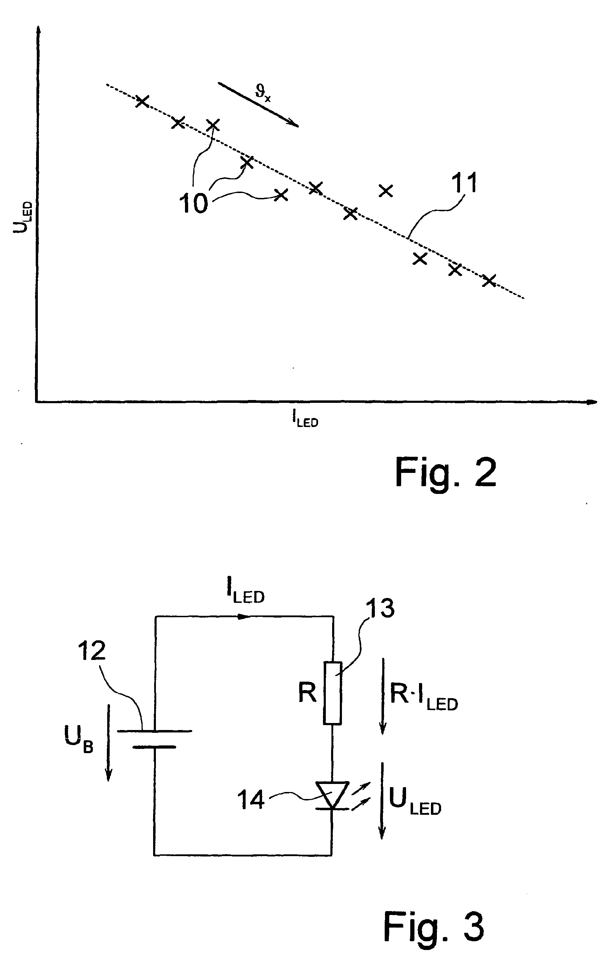

Trägt man wie in Fig. 2 dargestellt die hier erfaßten Meßdaten (10) für Strom und Durchlaßspannung in ein Strom-Spannungs-Diagramm ein, so ergibt sich ein Zusammenhang, der in vielen Fällen in guter Näherung als linear angesehen werden kann. Mit Hilfe einer Ausgleichsrechnung läßt sich dieser lineare Zusammenhang als Funktionsgleichung der Form

$$U_{LED} \;=\; m \cdot I_{LED} \;+\; U_B \qquad\qquad (1)$$

ausdrücken, die eine Ausgleichsgerade (11) beschreibt. Dabei fällt auf, daß die Konstante $m$ die Einheit V/A=$\Omega$ eines elektrischen Widerstands haben muß, und daß sie meist negativ ist, d.h. die Durchlaßspannung wird kleiner, obwohl der Strom zur Kompensation des durch Erwärmung hervorgerufenen Abfalls der Lichtleistung erhöht werden muß.

Faßt man die Konstante $m$ als Widerstand $-R$ auf und stellt Gl. 1 so um, daß auf beiden Seiten nur positive Größen stehen, erhält man

$$U_B \;=\; R \cdot I_{LED} \;+\; U_{LED} \qquad\qquad (2)$$

Das ist die Maschengleichung eines Stromkreises nach Fig. 3.

Es fällt zunächst nicht leicht, einzusehen, warum eine so einfache Schaltung den Temperatureinfluß auf die optische Ausgangsleistung von Leucht- oder Laserdioden kompensieren sollte, zumal diese Lichtquellen ja wahrlich oft mit ebendieser durchaus nicht innovativen Beschaltung betrieben werden und dabei kaum jemals ein stabilisierender Effekt beobachtet wird. Sie tut es auch nur unter der Voraussetzung, daß die wie oben beschrieben ermittelten Werte für $U_B$ und $R$ ziemlich genau eingehalten werden. Sinkt durch Erwärmung die Durchlaßspannung der Diode (14), so fällt am Widerstand $R$ (13) eine dementsprechend größere Spannung ab, die einen größeren Strom hervorruft, welcher seinerseits wiederum zu einer größeren Durchlaßspannung an der Diode führt. Es stellt sich also stabil ein neuer Strom ein, der größer als der ursprüngliche Strom ist, und wenn $U_B$ und $R$ genau die richtigen Werte aufweisen, kompensiert dieser neue Strom gerade den durch Erwärmung hervorgerufenen Abfall der Lichtleistung.

Der Grund, warum der Betrieb einer Leucht- oder Laserdiode mit Vorwiderstand an einer Spannungsquelle kaum jemals zu einer Temperaturstabilisierung führt, liegt einfach darin, daß die dazu erforderlichen Werte für $U_B$ und $R$ in der Praxis ungebräuchlich sind. Die Spannungen liegen etwa im Bereich 1...3 V und die Widerstände bei einigen wenigen Ohm. Die gebräuchlichen wesentlich größeren Spannungen und Vorwiderstände stellen aus der Sicht der Diode näherungsweise eine Konstantstromquelle dar, und damit kann keine Stabilisierung erreicht werden.

Im Folgenden werden die Bezeichnungen $U_B$ und $R$ immer im Sinne von Gl. 2 bzw. Fig. 3 gebraucht, also quasi als Parameter für den linearen Verlauf einer Linie gleicher Lichtleistung.

Es hat sich gezeigt, daß das Verfahren nicht in allen Fällen gleich gut funktioniert. Es gibt Diodentypen, die sich besser und solche, die sich schlechter stabilisieren lassen. Auch der Betrag der Lichtleistung, der stabil gehalten werden soll, ist dabei von Bedeutung. Mit Hilfe von Simulationsrechnungen läßt sich verstehen, warum das so ist, und wie sich besser geeignete Leucht- oder Laserdioden von weniger geeigneten unterscheiden lassen.

Von großer Bedeutung ist dabei der parasitäre Serienwiderstand, den eine jede Diode aufweist, und der dazu führt, daß sich der anfangs exponentielle Anstieg ihrer Durchlaßkennlinie bald einer - wenn auch steilen - Geraden annähert. Bei Leuchtdioden und Laserdioden ist dieser Serienwiderstand u.U. weitaus größer als z.B. bei Gleichrichterdioden, wo auf einen kleinen ohmschen Widerstand besonderer Wert gelegt werden muß. Er wird in Datenblättern mit Werten um 3...4 Ω angegeben, jedoch fehlen meist Angaben bezüglich Toleranzen und Temperaturgang.

Für die hier durchgeführten Simulationsrechnungen wurde das elektrische Verhalten der Diode durch eine ideale Diodenkennlinie mit einem in Serie geschalteten - u.U. temperaturabhängigen - Widerstand modelliert. Für die optische Ausgangsleistung erhält man das im Versuch beobachtete Verhalten, wenn man eine Abhängigkeit

$$ P_{LED} \sim I_{LED} \, / \, (1 + c\,(\vartheta - \vartheta_0)) \qquad\qquad (3) $$

unterstellt. Dabei steht $\vartheta$ für die Temperatur und $\vartheta_0$ für eine Bezugstemperatur, bei der die Lichtleistung einen Nominalwert annimmt. Mit der Konstanten $c$ läßt sich das Ausmaß der Temperaturabhängigkeit einstellen.

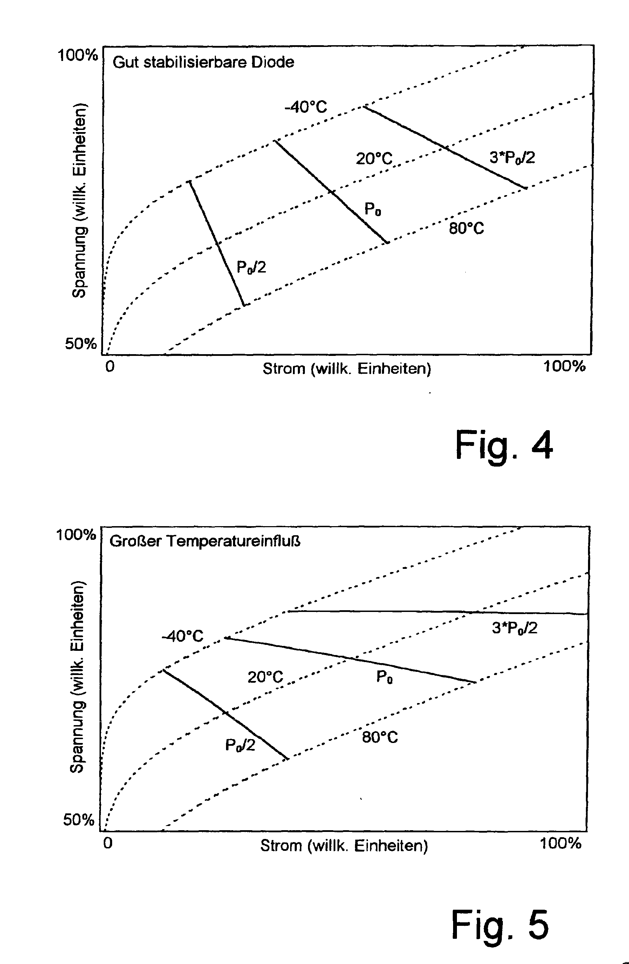

Fig. 4 zeigt analog zu Fig. 2 Linien konstanter Lichtleistung für eine gut stabilisierbare Leuchtdiode. Die gestrichelten Linien sind die Diodenkennlinien an den Grenzen und in der Mitte des simulierten Temperaturbereichs. Man sieht, daß der Wert von $R$, der der negativen Steigung der Geraden entspricht, umso kleiner gemacht werden muß, je größer man die Lichtleistung wählt. Die Spannung $U_B$ ändert sich dagegen wenig. Dioden mit einem solchen Verhalten, die tatsächlich verfügbar sind, sollten nach Möglichkeit bevorzugt eingesetzt werden.

Fig. 5 zeigt im Vergleich dazu die Ergebnisse bei einer Diode mit größerem Temperatureinfluß auf die Lichtleistung und sonst gleichen Daten. Hieraus wird ersichtlich, daß sowohl $U_B$ als auch $R$ umso kleiner werden, je größer der Temperatureinfluß wird. Der Grenzfall ist eine temperaturunabhängige Diode, bei der die Geraden senkrecht verlaufen würden, entsprechend unendlichem Widerstand und unendlich hoher Spannung bzw. dem Betrieb an einer Konstantstromquelle. Die Gerade bei $3\,P_0/2$ verläuft hier bereits nahezu waagrecht, und in der Tat gibt es Fälle, wo der parasitäre Serienwiderstand so groß ist, daß der Betrieb der Diode an einer Konstantspannungsquelle zu ihrer Stabilisierung führt.

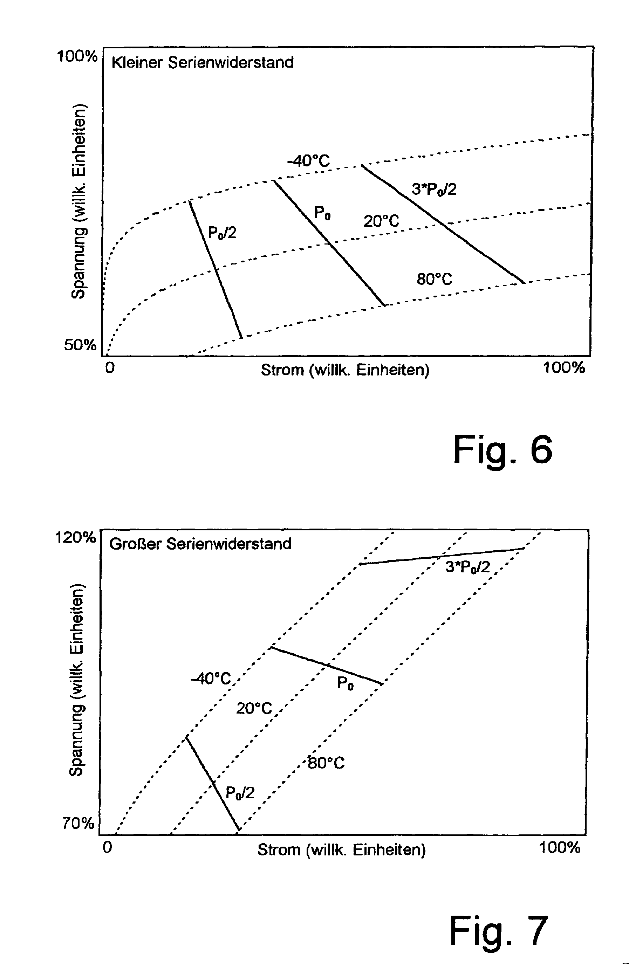

In Fig. 6 und Fig. 7 ist der Einfluß des parasitären Serienwiderstands dargestellt. Je größer er wird, desto flacher (hier steiler) werden die Diodenkennlinien, und desto kleiner muß der externe Widerstand $R$ zur Stabilisierung gewählt werden. Dabei ist es wie Fig. 7 zeigt durchaus möglich, daß der anhand von Fig. 5 erkennbare Fall einer waagrecht verlaufenden Geraden überschritten wird, was einen negativen äußeren Widerstand erforderlich machen würde.

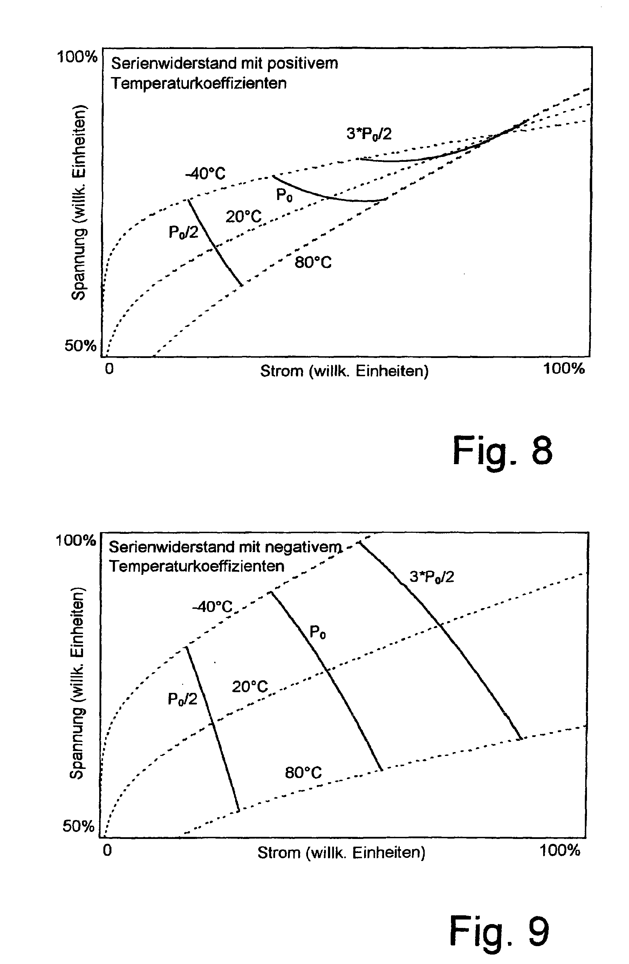

Aus Fig. 8 wird ersichtlich, wo die Grenzen des Verfahrens liegen: Hier wurde angenommen, daß der parasitäre Serienwiderstand mit der Temperatur ansteigt. Trivial ist, daß dann auch der äußere Widerstand $R$ nicht mehr konstant wählen läßt, was sich in der Krümmung der vormaligen Geraden äußert. Wichtiger aber ist, daß ein positiver Temperaturkoeffizient des parasitären Serienwiderstands zu sich schneidenden Diodenkennlinien führt, d.h. daß eine bestimmte Kombination aus Strom und Durchlaßspannung bei mehreren Temperaturen und folglich bei verschiedenen Lichtleistungen auftreten kann. Eine unmittelbare Folge von sich schneidenden Kennlinien ist, daß eine Kurve konstanter Lichtleistung in einem solchen Bereich nahezu parallel zu den Kennlinien verlaufen und sie u.U. mehrfach schneiden muß.

Eine elektronische Schaltung gleichwelcher Art kann somit aus der Kombination von Strom und Durchlaßspannung allein nicht mehr "entscheiden", ob die gegenwärtige Lichtleistung zu groß oder zu klein ist, und was dagegen zu "tun" wäre. Das äußert sich zwar nicht in einem instabilen Verhalten, jedoch immerhin darin, daß die Wirkung der Maßnahme zumindest stark zu wünschen übrig läßt, wenn nicht der Temperaturgang dadurch sogar noch verschlimmert wird. Dies gilt in umso stärkerem Maße, je mehr sich die gewählte Linie konstanter Lichtleistung dem Schnittpunkt bzw. -bereich der Diodenkennlinien nähert. Bleibt sie diesem ausreichend fern, wie beispielsweise die Linie für $P_0/2$ in Fig. 8, kann dennoch eine recht brauchbare Temperaturstabilisierung erreicht werden. Leuchtdioden mit einem Verhalten ähnlich dem in Fig. 8 dargestellten sind aus der Praxis bekannt.

Fig. 9 zeigt den gegenteiligen Fall eines negativen Temperaturkoeffizienten des parasitären Serienwiderstands. In der Praxis ist ein solches Verhalten noch nicht bekannt geworden, doch muß immerhin damit gerechnet werden, daß es möglich ist. Man erkennt, daß die Divergenz der Diodenkennlinien zu allgemein größeren Steigungen der Linien konstanter Lichtleistung fuhrt. Trotz der auch hier erkennbaren Krümmung kann sich ein solches Verhalten als für manche Anwendungsfälle vorteilhaft erweisen. Es ist nämlich zu erwarten, daß die Werte für $U_B$ und $R$ umso kritischer werden, je spitzer der Winkel ist, unter dem die Diodenkennlinien die Linien konstanter Lichtleistung schneiden. Da die Bauteile, mit denen die Diode beschaltet wird, ebenfalls Temperatureinflüssen unterworfen sind, sollten sie nach Möglichkeit nicht am Einsatzort der Diode untergebracht werden, sondern an einem Ort, wo keine großen Temperaturschwankungen herrschen. Ist das nicht möglich, kann der Einsatz einer Diode, deren Serienwiderstand einen negativen Temperaturkoeffizienten aufweist, zu besseren Ergebnissen führen, obwohl der Temperaturgang auch theoretisch nicht exakt kompensiert werden kann.

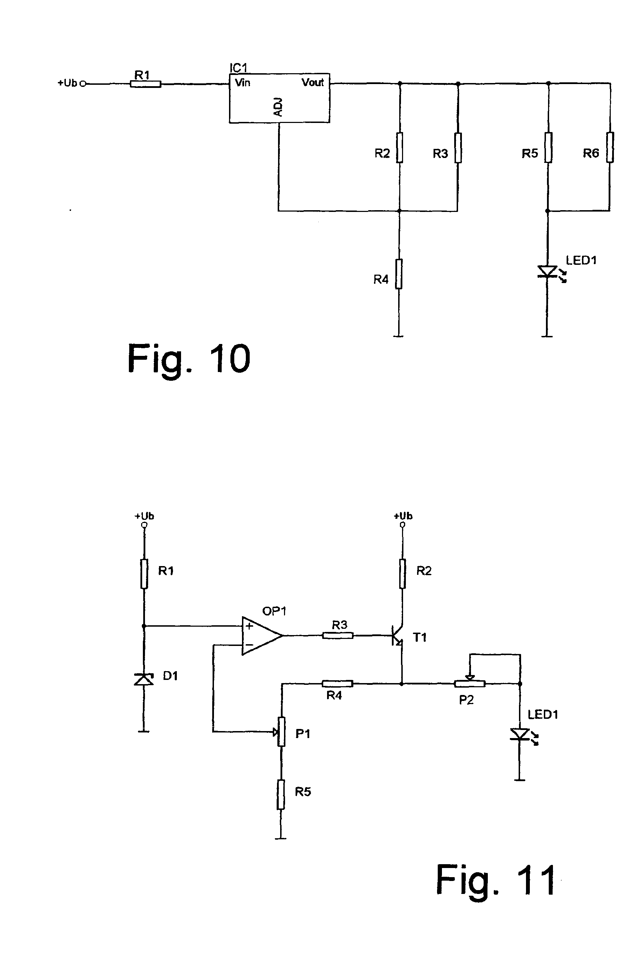

Eine sehr einfache Möglichkeit zur praktischen Anwendung des Verfahrens stellt die Schaltung in Fig. 10 dar. Bei dem integrierten Schaltkreis IC1 handelt es sich um einen Spannungsregler von der Art des Typs LM 317 der Firma NATIONAL. Solche Regler stellen die Spannung am Anschluß Vout so ein, daß die Spannung zwischen den Anschlüssen Vout und ADJ gleich einer intern erzeugten Referenzspannung wird. Mit Hilfe des Spannungsteilers aus R4 und der Parallelschaltung von R2 und R3 läßt sich der Regler mit ausreichender Genauigkeit auf den erforderlichen Wert für $U_B$ einstellen. Der Widerstand $R$ wird mit der Parallelschaltung aus R5 und R6 erzeugt.

Der Widerstand R1 dient dazu, den Spannungsabfall und damit die Verlustleistung an IC1 möglichst klein zu halten. Die große Einfachheit der Schaltung wird nämlich durch den Nachteil erkauft, daß sich die Leistungsstufe der Regelschaltung und die Referenzspannungsquelle auf einem gemeinsamen Chip befinden. Ändert sich die Referenzspannung aufgrund von Temperatureinflüssen, so ändert sich auch $U_B$, und die Lichtleistung kann somit nicht stabil bleiben. Es ist also vorteilhaft, die Erzeugung der Referenzspannung örtlich möglichst von Wärmequellen zu entfernen, und das wird mit R1 hier zumindest teilweise erreicht.

Eine weitere Eigenheit der Schaltung nach Fig. 10 ergibt sich daraus, daß die Spannung $U_B$ und der Widerstand $R$ mit Festwiderständen eingestellt werden. Diese Maßnahme ist auch bei den nachfolgenden Schaltungen jederzeit möglich, sie bietet Vorteile hinsichtlich Zuverlässigkeit, Baugröße und Bauteilepreis. Um die Festwiderstände jedoch richtig zusammenstellen zu können, muß das Verhalten der Diode im Voraus bekannt, d.h. ermittelt worden sein, und es ist u.U. erforderlich, jede einzelne Schaltung gesondert zu bestücken, was Preisvorteile sicherlich relativiert.

Die Schaltung nach Fig. 11 soll alternative Ausgestaltungsmöglichkeiten aufzeigen. Die Referenzspannung wird hier im einfachsten Fall mit einer Zener-Diode D1 erzeugt. Es ist aber zu empfehlen, hier ein gutes Band-Gap-Referenzelement einzusetzen. Die Spannung $U_B$ wird durch OP1 am Emitter von T 1 erzeugt und kann mit dem Spannungsteiler aus R4, P1 und R5 stetig variiert werden. Legt man diesen Spannungsteiler nur einigermaßen hochohmig aus, so sind die hauptsächlichen Wärmequellen in dieser Schaltung R2 und T1. Sie können thermisch isoliert von D1 und auch von OP1 eingebaut werden, dessen Offsetspannung temperaturabhängig sein kann. Der Widerstand R wird hier einstellbar mit P2 realisiert, sodaß die Schaltung die Stabilisierung unterschiedlicher Lichtleistungen erlaubt.

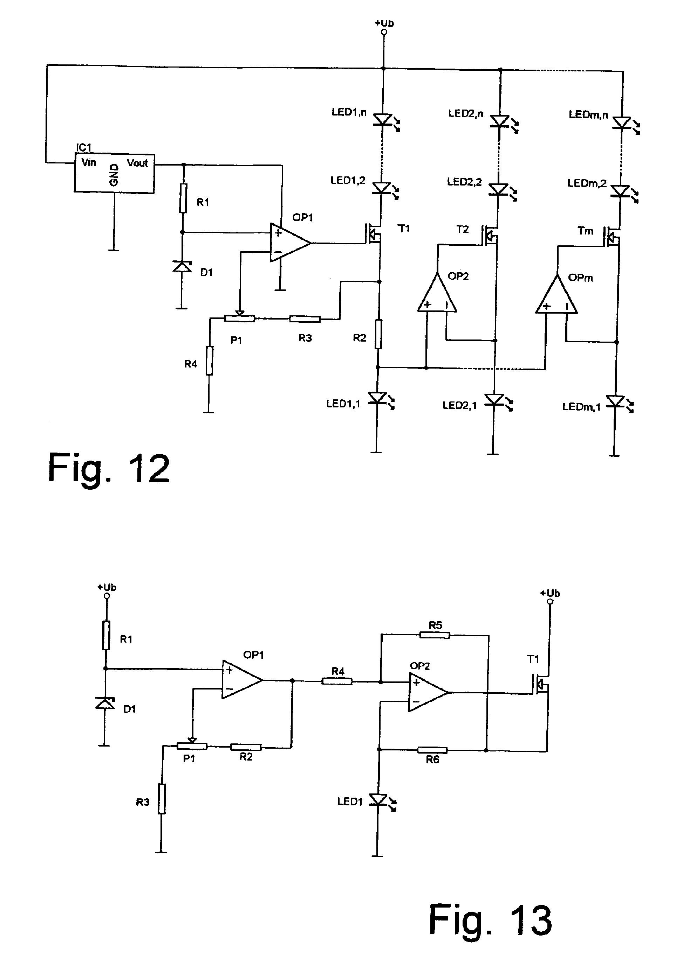

Für Fälle, wo mehrere - u.U. zahlreiche - Leuchtdioden stabilisiert werden sollen, wie es z.B. für Verkehrsampeln gefordert wird, zeigt Fig. 12 zwei gleichermaßen vorteilhafte Möglichkeiten des beschriebenen Verfahrens. Man wird in einem solchen Fall meist bestrebt sein, eine gewisse Zahl von Dioden in Serie zu schalten, um bei einer gebräuchlichen Betriebsspannung von z.B. 10...24 V die Leistungsverluste klein zu halten. Die Stabilisierung einer solchen Serienschaltung aus Leuchtdioden kann kanz einfach bewerkstelligt werden, indem eine einzelne LED (hier LED1,1) wie in Fig. 11 dargestellt stabilisiert und ihr die restlichen Dioden (LED1,2 bis LED1,n) in Serie geschaltet werden, sodaß über sie der gleiche Strom fließt. Dazu ist es vorteilhaft, den bipolaren Transistor T1, in dessen Emitterkreis auch noch der Basisstrom fließt, durch einen n-Kanal-MOSFET zu ersetzen, dessen Gate hochohmig ist. Der Spannungsteiler aus R3, P1 und R4 muß natürlich hochohmig genug ausgelegt werden, daß der über ihn fließende Strom klein gegen jenen ist, der durch die LED's fließt.

Greift man die an LED 1,1 abfallende Durchlaßspannung ab, kann man den Strom durch beliebig viele weitere Leuchtdioden LED2,1...LEDm,1 mit Hilfe weiterer Operationsverstärker OP2... OPm und weiterer MOSFET's T2... Tm so regeln, daß sich an diesen Dioden die gleiche Durchlaßspannung einstellt. Gleichen diese Dioden LED1,1 vom Typ her, und haben sie die gleiche Temperatur, so fließt durch sie auch der gleiche Strom, sodaß ihre Lichtleistung ebenfalls stabilisiert wird. Sie können in gleicher Weise wie LED1,1 mit weiteren Leuchtdioden LED2,2...LEDm,n in Serie geschaltet werden, sodaß sich die Stabilisierung von LED1,1 auf eine ganze Matrix aus Leuchtdioden ausdehnen läßt. Die MOSFET's T1...Tm dürfen dabei preiswerte Kleinleistungstypen sein, für die u.U. noch nicht einmal Kühlkörper erforderlich sind.

LED1,1 wirkt in der Schaltung nach Fig. 12 als Temperatursensor für die restlichen LED's. Die Stabilisierung von LED's mit Hilfe des Meßwerts eines gesonderten Temperatursensors ist an sich kein neues Konzept, doch stellt LED1,1 einen überaus vorteilhaften Temperatursensor dar: Sie läßt sich exakt wie die restlichen LED's einbauen und ist somit genau den gleichen thermischen Einflüssen ausgesetzt. Sie weist weiterhin genau die gleichen thermischen Eigenschaften wie die anderen LED's auf, sodaß sich aus den besagten thermischen Einflüssen auch die gleichen Temperaturänderungen ergeben müssen. Weiterhin gehört zu diesen thermischen Einflüssen auch die Eigenerwärmung aufgrund der im Betrieb auftretenden Verlustleistung, was von LED1,1 ebenfalls erfaßt wird. Zuletzt erfordert die Umsetzung des Meßsignals in Stellgrößen für die restlichen LED's keinerlei Signalverarbeitung, da hier Meßsignale und Stellgrößen in gewisser Weise ein und dasselbe sind.

Ein weiterer Vorteil des Verfahrens ergibt sich daraus, daß die Versorgungsspannung +Ub in Fig. 12 nicht stabilisiert zu werden braucht. Eine stabile Betriebsspannung ist lediglich für die Erzeugung der Referenzspannung mit D1 und R1 und für die Operationsverstärker zu empfehlen. Da die Stromaufnahme dieser Schaltungsteile recht klein gestaltet werden kann (die Operationsverstärker brauchen so gut wie keine Ausgangsströme zu liefern), genügt hierzu ein preiswerter Linearregler IC1, etwa vom bekannten Typ 7805, der keine besonderen Kühlmaßnahmen verlangt. Da Anordnungen aus zahlreichen Leuchtdioden vor allem im Hinblick auf ihren geringen Energieverbrauch eingesetzt werden, ist die Möglichkeit, die Verlustleistung auf das unbedingt notwendige Maß beschränken zu können als wichtiges Qualitätsmerkmal einer gleichwie gearteten Ansteuerschaltung anzusehen.

Wie aus Fig. 7 ersichtlich wird, muß durchaus damit gerechnet werden, daß in bestimmten Fällen die Linie konstanter Lichtleistung über dem Strom nicht abfällt sondern ansteigt. Fällt sie ab, so muß von einer konstanten Spannung $U_B$ ein dem Strom proportionaler Wert abgezogen werden, um die erforderliche Durchlaßspannung der Diode zu erhalten, was einfach durch Hinzuschalten eines Widerstands erreicht werden kann. Steigt sie jedoch an, so muß dieser Wert zu $U_B$ hinzuaddiert werden. Man kann das als Subtraktion eines negativen Werts auffassen, der sich durch Einsatz eines negativen Widerstands bilden läßt.

Negative Widerstände sind keine passiven Bauteile mehr und benötigen sogar eine Spannungsversorgung, doch lassen sie sich mit Hilfe eines Operationsverstärkers leicht aufbauen. Die in Fig. 13 dargestellte Schaltung macht von diesem Ansatz Gebrauch. Am Ausgang von OP1 wird die Spannung $U_B$ eingestellt. Anders als bei den bis hierher angegebenen Schaltungen wird diese Spannung hier kaum noch belastet, sodaß sich eine Treiberstufe an dieser Stelle erübrigt. Die Schaltung aus OP2, T1, R4, R5 und R6 verhält sich wie ein negativer Widerstand, dessen Wert

$$R = -R_6 / (1 + R_5/R_4) \tag{4}$$

beträgt, und der zwischen den Ausgang von OP1 und die Anode von LED1 geschaltet ist. Diese Schaltung liefert nur an einem ihrer Anschlüsse den Strom, der über einen hypothetischen negativen Widerstand fließen würde, deshalb simuliert sie das Verhalten eines solchen nur, wenn der andere Anschluß auf einer festen Spannung, z.B. Masse liegt. $U_B$ am Ausgang von OP1 ist jedoch eine solche feste Spannung, und der Strom für die LED oder Laserdiode wird am anderen Anschluß benötigt, wo er unter Zuhilfenahme von T1 leicht zur Verfügung gestellt werden kann. Zu bemerken ist weiterhin, daß es sich bei der hier eingesetzten Schaltung für den negativen Widerstand um eine s.g. leerlaufstabile Variante handelt. Simulationsrechnungen haben ergeben, daß kurzschlußstabile (=leerlauf-instabile) Schaltungen hier kein ausreichend definiertes Verhalten zeigen. Der Grund dafür ist wohl, daß die Diode im stromlosen Zustand einen sehr hohen scheinbaren Widerstand aufweist, sodaß die Schaltung in diesem Fall mit einem quasi-offenen Anschluß betrieben wird und sich nicht mehr definiert einschwingen kann.

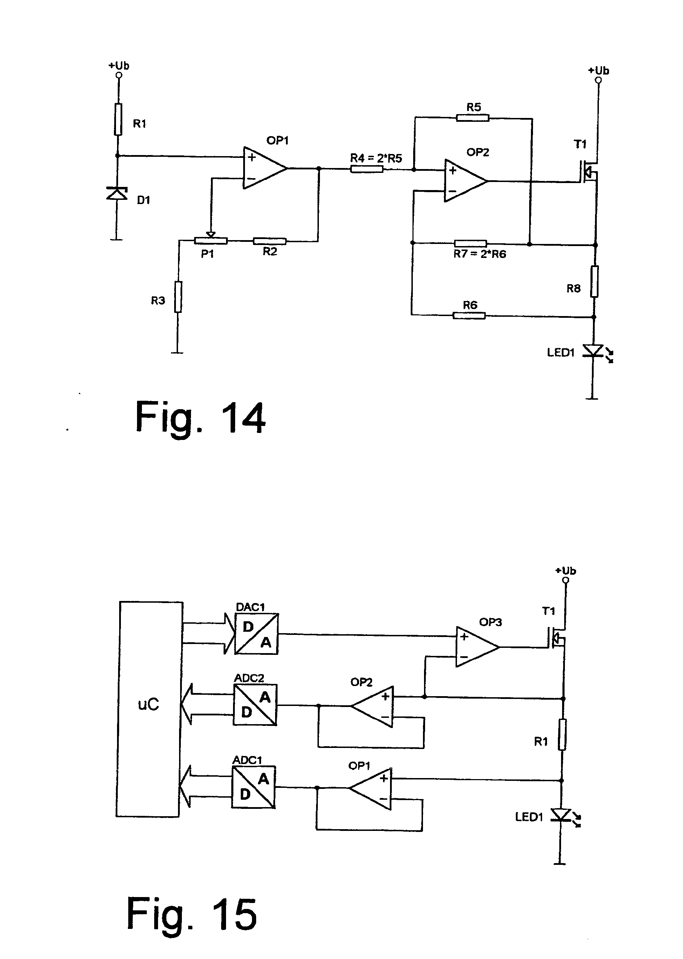

Die Schaltung gemäß Fig. 14 dient ebenfalls zur Stabilisierung von Dioden mit über dem Strom ansteigender Linie konstanter Lichtleistung. Sie sieht der Schaltung nach Fig. 13 recht ähnlich, beruht jedoch auf einem anderen Denkansatz. Am Ausgang von OP1 wird wieder die Spannung $U_B$ eingestellt. Sie dient als Bezugspotential für den als Differenzverstärker mit Verstärkung Zwei geschalteten OP2 mit der Treiberstufe T1, an dessen Ausgang (d.h. an der Source von T1) sich folglich die Spannung

$$U_{diff} = U_B + 2 \cdot R_8 \cdot I_{LED} \tag{5}$$

einstellt, falls die Widerstände R4...R7 groß genug gegen R8 dimensioniert werden. Da unter der gleichen Voraussetzung auch gilt

$$U_{LED} = U_{diff} - R_8 \cdot I_{LED} \tag{6}$$

ergibt sich

$$U_{LED} = U_B + R_8 \cdot I_{LED} \tag{7}$$

sodaß sich die Schaltung zwischen dem Ausgang von OP1 und der Anode von LED1 auch hier wieder wie ein negativer Widerstand, allerdings mit dem Wert $R = -R_8$ verhält.

Wird das Verfahren wie bis hierher beschrieben unter ausschließlichem Einsatz von Analogtechnik ausgeführt, ist seine Anwendung insofern eingeschränkt, als die stabilisierte Lichtleistung nicht ohne Weiteres variiert werden kann. Das liegt daran, daß hierzu sowohl $U_B$ als auch $R$ gemeinsam verändert werden müssen, wobei zwischen beiden Größen ein funktionaler Zusammenhang einzuhalten ist. Dies ist analogtechnisch zumindest sehr aufwendig, läßt sich aber digital, insbesondere in Form von Software eines Mikrocontrollers ($\mu$C) sehr einfach realisieren. Dazu ist lediglich eine Anordnung nach Fig. 15 erforderlich, die sich zudem unter bestimmten Umständen noch vereinfachen läßt.

Mit Hilfe eines Analog-Digital-Wandlers ADC1 wird hier die Durchlaßspannung der Leucht- oder Laserdiode LED1 gemessen, wobei der Operationsverstärker OP1 entweder wie gezeichnet nur als Impedanzwandler wirkt oder auch als nichtinvertierender Verstärker geschaltet werden kann, weil die Meßbereiche gängiger A/D-Wandler doch deutlich größer sind als die hier auftretenden Spannungen. Je nach Ausführung des eingesetzten A/D-Wandlers kann er u.U. auch ganz weggelassen werden.

Der durch LED 1 fließende Strom ergibt sich dadurch, daß zusätzlich zur Spannung an LED 1 auch noch die Spannung am positiven Anschluß eines dazu in Serie geschalteten Widerstands R1 ermittelt wird, der in diesem Falle nichts mit dem Widerstand $R$ aus Gl. 2 bzw Fig. 3 zu tun hat. Das kann sowohl dadurch geschehen, daß sie mit Hilfe von ADC2 und OP2 in gleicher Weise gemessen wird, als auch durch wohldefinierte Steuerung über einen Digital-Analog-Wandler DAC1 und eine aus OP3 und T1 bestehende Verstärkerschaltung. Mißt man sie, so kann die D/A-Schnittstelle zur Steuerung des Stroms recht einfach ausgelegt werden, erscheint es hingegen günstiger, letztere sehr präzise zu machen, so erübrigt sich die Messung.

Der zyklisch zu wiederholende Algorithmus zur Stabilisierung der LED oder Laserdiode ergibt sich dann sehr einfach aus der Forderung, daß Gl. 2 erfüllt sein muß: Zunächst werden wie oben beschrieben $U_{LED}$ und $I_{LED}$ ermittelt. Ist der Wert des Ausdrucks $R \cdot I_{LED} + U_{LED}$ kleiner als $U_B$, wird der Strom bzw. der an die D/A-Schnittstelle ausgegebene Wert erhöht, andernfalls erniedrigt. Beim Programmstart wird dieser Wert mit 0 initialisiert. Man kann zusätzlich abfragen, ob Gl. 2 genau erfüllt ist, in welchem Fall überhaupt keine Aktion zu erfolgen braucht, doch ist das nicht erforderlich.

Das individuelle Verhalten der LED oder Laserdiode bei einer bestimmten Lichtleistung wird hier durch nur zwei Konstanten beschrieben, $U_B$ und $R$. Es bereitet keine Schwierigkeiten, diese Konstanten als Funktion irgendeiner der Lichtleistung entsprechenden Variablen aufzufassen und sie einer vorher erstellten Tabelle zu entnehmen bzw. Zwischenwerte zu interpolieren. Mit Hilfe des Mikrocontrollers ($\mu$C) kann also die stabilisierte Lichtleistung sehr einfach variabel gestaltet werden. Dazu ist nur äußerst wenig Rechenleistung und Speicherplatz notwendig, und auch der Programmieraufwand ist sehr gering.

Der Algorithmus funktioniert sowohl für positive als auch für negative Werte von $R$. Er funktioniert sogar dann, wenn für die Linie konstanter Lichtleistung der Zusammenhang zwischen Strom und Spannung nichtlinear ist. In diesem Fall kann dieser Zusammenhang natürlich nicht mehr einfach durch zwei Konstanten $U_B$ und $R$ beschrieben und mit Gl. 2 berechnet werden. Der Algorithmus kann jedoch nicht in einem Bereich funktionieren, wo sich Diodenkennlinien schneiden (s. Fig. 8), weil sich dort nicht mit ausreichender Sicherheit entscheiden läßt, ob die Kombination aus Strom und Durchlaßspannung "unter" oder "über" der Linie konstanter Lichtleistung liegt.

Alle Schaltungen von Fig. 13 bis Fig. 15 lassen sich analog zu Fig. 12 zur Stabilisierung einer ganzen Matrix von LED's erweitern. Voraussetzung hierfür ist lediglich der Einsatz eines MOSFETs als Treiberstufe und daß die Kathode der LED an Masse liegt, was bei den genannten Schaltungen der Fall ist.

Eine Modulation, d.h. ein Ein- und Ausschalten des von der Leuchtdiode oder Laserdiode ausgesandten Lichts zum Zweck einer Eliminierung des Einflusses von Umgebungslicht oder um den Stromverbrauch zu reduzieren kann am einfachsten dadurch erfolgen, daß die Spannung $U_B$ in geeigneter Weise zu Null gemacht wird. Wird sie so erzeugt, wie in den Schaltungen nach Fig. 11 bis Fig. 14, bietet sich hierzu z.B. ein Kurzschließen der Referenzdiode D1 an. Die möglichen Modulationsfrequenzen werden dann durch die Einschwingzeiten der eingesetzten Operationsverstärker bestimmt. Da diese durchweg deutlich unter 100 $\mu$s liegen sollten, dürften Modulationsfrequenzen bis zu einigen Kilohertz keine Schwierigkeiten bereiten.

Eine Schaltung nach Fig. 10 eignet sich nicht besonders gut zur Modulation, denn ein Spannungsregler des dort eingesetzten Typs kann nur schlecht dazu gebracht werden, eine Spannung nahe Null auszugeben. Man müßte hierzu die Versorgung unterbrechen; da jedoch bei Verwendung von integrierten Spannungsreglern meist Pufferkondensatoren nötig werden, können hier keine besonders hohen Taktfrequenzen erzielt werden. Eine ausgangsseitige Unterbrechung des Stroms ist nicht zu empfehlen, denn der dazu nötige Schalter hat immer einen gewissen Widerstand und liegt zu $R$ in Serie, verfälscht also dessen Wert.

Bei Einsatz eines Mikrocontrollers nach Fig. 15 ergeben sich leichte Einschränkungen der Modulierbarkeit. Während bei den obengenannten Schaltungen das elektrische Verhalten der LED oder Laserdiode ihr optisches direkt beeinflußt, müssen hier ihre momentanen elektrischen Eigenschaften erst ermittelt werden, bevor sie sich auf das optische Verhalten auswirken können. Das kann jedoch nicht geschehen, wenn die Diode ausgeschaltet ist. Wie sich das auswirkt, hängt davon ab, wie sich Modulationsfrequenz, Meßrate und die Geschwindigkeit interner und externer Temperatureinflüsse zueinander verhalten. Ist die Modulationsfrequenz so hoch, daß sich die Chiptemperatur zwischen zwei Einschaltphasen nicht wesentlich ändern kann oder wird die Diode nur sehr kurz ausgeschaltet, um die Umgebungshelligkeit zu messen, kann der $\mu$C beim Wiedereinschalten mit den alten Meßwerten fortfahren. Speziell im Falle einer hohen Modulationsfrequenz wird dann aber eine gleichermaßen hohe Meßrate bzw Verarbeitungsgeschwindigkeit erforderlich. Werden die Ausschaltphasen hingegen so lang, daß sich der Chip in dieser Zeit merklich abkühlen oder gar Änderungen der Umgebungstemperatur folgen kann, muß nach dem Einschalten die Linie konstanter Lichtleistung erst wieder neu angefahren werden. Damit das schnell geht, sind auch hier wieder kurze Zykluszeiten wünschenswert. Es kann also ausgesagt werden, daß bei Modulation des Lichts die Anforderungen an die Leistung des Mikrocontrollers grundsätzlich steigen, und es mag sein, daß zwischen den beiden Extremfällen hoher und niedriger Modulationsfrequenzen solche exisitieren, bei denen eine Stabilisierung der LED oder Laserdiode gar nicht möglich ist.

Die hier angegebenen Schaltungsbeispiele sind als Prinzipschaltungen zu verstehen. Bauteile, die nicht zu ihrem Verständnis notwendig sind, wurden weggelassen. Dazu gehört vor allem die oft notwendige Schutzbeschaltung für die Leuchtdiode oder Laserdiode. Speziell Laserdioden aber auch viele lichtstarke und deshalb teure LED's sind sehr empfindlich gegen Überspannungen sowohl in Durchlaß- als auch in Sperrichtung. Eine antiparallel geschaltete Z-Diode, deren Durchbruchspannung etwas über der maximal auftretenden Flußspannung $U_{LED}$ liegt, kann diese Bauteile bereits vor Schaden bewahren. Es muß auch angemerkt werden, daß die angegebenen Schaltungen je nach den eingesetzten Bauteilen beim Einschalten der Versorgung oder bei Modulation kurzfristig Überspannungen erzeugen können, vor denen die Diode z.B. durch Einsatz geeigneter Pufferkondensatoren zu schützen ist.

Die Ermittlung der Werte für die Konstanten $U_B$ und $R$ mit dem eingangs angegebenen Meßaufbau nach Fig. 1 ist etwas umständlich. Ein solcher Meßaufbau ist kaum entbehrlich wenn es um die Ermittlung des prinzipiellen Verhaltens eines unbekannten Typs von Leucht- oder Laserdiode geht. Ist dieses Verhalten jedoch bekannt, und sollen Leuchtdioden oder Laserdioden in Stückzahlen stabilisiert werden, wäre es - auch verwaltungstechnisch - sehr aufwendig, alle Bauteile vor dem Einbau zu vermessen und die Schaltung dann anhand dieser Meßergebnisse abzugleichen. Ein solcher Abgleich wäre auch nicht besonders genau, denn wie z.B. aus Fig. 4 zu ersehen ist muß die bei der Messung gewonnene Punktwolke quasi extrapoliert werden, um den Wert für $U_B$ zu erhalten: $U_B$ entspricht nach Gl. 2 dem Wert von $U_{LED}$ für $I_{LED}=0$ und kann also nicht direkt gemessen werden. Dadurch und auch, weil der spätere Abgleich erfolgen muß, ohne daß die Stabilisierung der Lichtleistung dabei beobachtet werden kann, wird es schwierig, die Werte einzustellen, die die maximale Temperaturstabilität ergeben.

Weitaus günstiger ist es, die Leuchtdiode oder Laserdiode zuerst in die Schaltung einzubauen, und das Verhalten der letzteren dann im Betrieb so abzugleichen, daß die Lichtleistung stabil bleibt. Dazu ist es erforderlich, den Temperatureffekt auf die Lichtleistung irgendwie anzuzeigen. Das gelingt dadurch, daß man sich die Eigenerwärmung der LED oder Laserdiode nach dem Einschalten zunutze macht. Günstig ist dabei, daß das ein recht schneller Vorgang ist, denn aufgrund der kleinen Abmessungen der Chips weisen diese auch kleine Wärmekapazitäten auf, und ihre Temperatur steigt nach dem Einschalten des Stroms sehr rasch.

Man bringt dazu die Schaltung in eine geeignete Vorrichtung ein, mit deren Hilfe sich die ausgesandte Lichtleistung ohne störenden Einfluß von Umgebungslicht messen läßt und schaltet den Strom mit einem geeigneten Taktgeber periodisch ein und aus. Das kann durch Ein- und Ausschalten der Versorgungsspannung geschehen, jedoch auch, indem eine eventuell vorgesehene Möglichkeit zur Modulation genutzt wird. Das Meßsignal für die Lichtleistung stellt man dann z.B. auf einem Oszillographen dar.

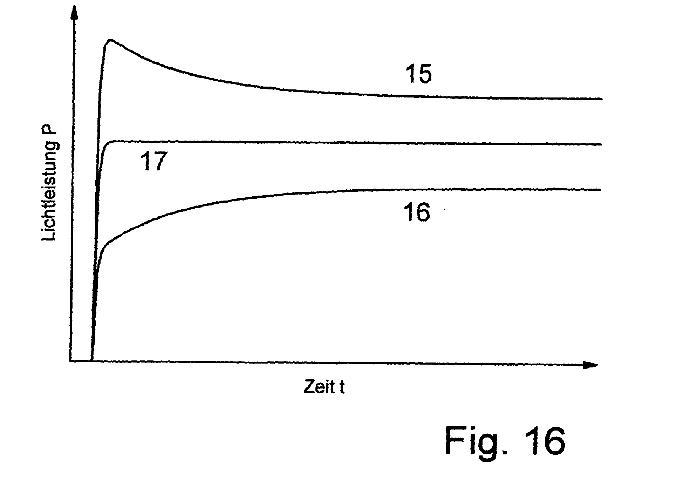

Beispiele für die sich hierbei ergebenden Zeitverläufe sind qualitativ in Fig. 16 dargestellt. Eine unstabilisierte Diode oder eine solche mit unterkompensiertem Temperaturgang zeigt beim Einschalten ein Verhalten ähnlich der Kurve 15: Die Lichtleistung wächst zunächst rasch an und sinkt dann wieder, weil die Temperatur steigt. In einem solchen Fall ist entweder der Widerstand $R$ oder die Spannung $U_B$ zu verkleinern, je nachdem, ob die Asymptote der Kurve unter oder über der gewünschten Lichtleistung liegt. Zeigt die Lichtleistung einen Verlauf ähnlich der Kurve 16, liegt eine Überkompensation vor, die durch wahlweises Vergrößern von $R$ oder $U_B$ ausgeglichen werden kann. Kurve 17 entspricht dem Verlauf der Lichtleistung bei einer richtig gewählten Kombination von $R$ und $U_B$.

Fig. 16 illustriert einen Abgleich unter alleiniger Variation von $U_B$. Wird nur $R$ variiert, so liegt die unterkompensierte, abfallende Kurve unter der für den kompensierten Fall, die überkompensierte hingegen darüber. Fordert man nicht die Einhaltung einer ganz bestimmten Lichtleistung, dürfte es am günstigsten sein, den Widerstand $R$ fest vorzuwählen und den Abgleich nur durch Variation von $U_B$ durchzuführen. Gestaltet man dann noch die Schaltung so, daß $U_B$ z.B. mit Hilfe eines D/A-Wandlers erzeugt wird und schreibt den beim Abgleich als richtig befundenen Wert in einen nichtflüchtigen Speicher, so läßt sich der Abgleich vollautomatisch mit rein datentechnischen Mitteln am fertig montierten Gerät durchführen.

Die hier beschriebene Abgleichmethode bietet auch eine Möglichkeit zum Selbstabgleich der Lichtquellen von Meßgeräten, da solche meist auch einen Photodetektor enthalten werden, der das von der Lichtquelle ausgesandte Licht empfängt. Wird hier sowohl die Signalverarbeitung als auch die Stabilisierung der Lichtquelle vom gleichen Mikrocontroller (s. Fig. 15) erledigt, läßt sich dieser so programmieren, daß er bei einem definierten Zustand der Meßstrecke die notwendigen Daten zur Stabilisierung der Lichtquelle bei einer wohldefinierten Lichtleistung selbst ermitteln kann.

Diese Daten bestehen - wie bei der Beschreibung von Fig. 15 gesagt - in Normalfall lediglich aus zwei Konstanten für $U_B$ und $R$. Da der Mikrocontroller sowohl das Licht nach Belieben ein- und ausschalten kann als auch Zugriff auf den Zeitverlauf der Lichtleistung hat, ist er in der Lage, durch iterative Variation dieser Konstanten den oben beschriebenen Abgleichvorgang eigenständig durchzuführen. Dabei kann er von vorgegebenen Näherungswerten ausgehen, z.B. den beim letzten Abgleich ermittelten. Er kann aber auch selbst Näherungswerte ermitteln, indem er nämlich zunächst bei einem Einschaltvorgang durch

Regelung eine konstante Lichtleistung erzwingt und währenddessen den dazu nötigen Strom $I_{LED}$ und die sich daraus ergebende Spannung $U_{LED,}$ die er ja ebenfalls messen muß, protokolliert. Das ist nichts anderes als mit einer Meßanordnung nach Fig. 1 getan wird. Aus den gemessenen Daten können $U_B$ und R in gleicher Weise ermittelt werden. Man kann nicht erwarten, daß sie ebenso genau sind, doch als erste Näherung für einen anschließenden iterativen Feinabgleich werden sie sicher tauglich sein.

Auf diese Weise lassen sich auch nichtlineare Verläufe der Linie konstanter Lichtleistung handhaben. Die Komplexität der Vorgehensweise wächst dann natürlich u.U. drastisch, doch in Fällen, wo die betreffende Leuchtdiode oder Laserdiode trotz ihres zur Stabilisierung weniger günstigen Verhaltens eingesetzt werden muß, steht dieser Weg immerhin offen.

Mit der vorgeschlagenben Erfindung können Leuchtdioden oder Laserdioden durch eine diskrete Beschaltung gemäß den Figuren 10 bis 15 stabilisiert werden. Dies kann auch durch ein Zusatzmodul erfolgen, das eine Schaltung gemäß den Figuren 10 bis 15 enthält Die Schaltungen können auch ein Mikro-Konroller-Interface und durch entsprechende Software realisiert werden. Ebenso ist dieses durch eine an die Anforderungen und Kundenwünsche angepasste integrierte Schaltung möglich. Die Stabilisierungsschaltung kann auch in der Leuchtdiode integriert sein.

**Patentansprüche**

1. Verfahren zur Stabilisierung der optischen Ausgangsleistung (Lichtleistung) von Leuchtdioden und Laserdioden, wobei die Kombination aus Diodenstrom und Durchlassspannung als eindeutiges Maß für die von der Leuchtdiode oder Laserdiode ausgesandte Lichtleistung dient, wobei vorausgesetzt wird, dass unabhängig von der Temperatur bei konstanter Lichtleistung die Durchlassspannung eine Funktion des Diodenstroms ist, wobei die Funktion, durch die sich bei einer bestimmten konstanten Lichtleistung die Durchlassspannung aus dem Diodenstrom ergibt, durch Messungen von Diodenstrom und Durchlassspannung bei konstanter Lichtleistung bei verschiedenen Temperaturen ermittelt wird und wobei die Leuchtdiode oder Laserdiode zu deren Stabilisierung derart betrieben wird, dass der durch die Messung ermittelte funktionale Zusammenhang zwischen Durchlassspannung und Diodenstrom eingehalten wird.

2. Verfahren nach Anspruch 1, bei dem die Leuchtdiode oder Laserdiode so beschaltet wird, dass sich der durch die Messung ermittelte funktionale Zusammenhang zwischen Diodenstrom und Durchlassspannung allein aufgrund elektrischer Mechanismen einstellt, ohne die Notwendigkeit der Messung von Lichtleistung oder Temperatur während der Stabilisierung.

3. Verfahren nach Anspruch 2, bei dem mit Hilfe einer geeigneten Datenverarbeitungseinrichtung die Durchlassspannung über eine Analog-Digital-Schnittstelle gemessen, und der Diodenstrom über eine Digital-Analog-Schnittstelle so gesteuert wird, dass sich zwischen eingestelltem Diodenstrom und gemessener Durchlassspannung der vorher ermittelte funktionale Zusammenhang ergibt.

4. Verfahren nach Anspruch 2, bei dem vorausgesetzt wird, dass die Funktion, durch die sich bei konstanter Lichtleistung die Durchlassspannung aus dem Diodenstrom ergibt, eine lineare Funktion ist.

5. Verfahren nach Anspruch 4, bei dem im Falle einer bei konstanter Lichtleistung und zunehmendem Diodenstrom gleichbleibenden Durchlassspannung dieser Zusammenhang durch Betrieb der Leuchtdiode oder Laserdiode an einer Konstantspannungsquelle hergestellt wird.

6. Verfahren nach Anspruch 4, bei dem im Falle einer bei konstanter Lichtleistung und zunehmendem Diodenstrom linear abfallenden Durchlassspannung dieser Zusammenhang durch Betrieb der Leuchtdiode oder Laserdiode zusammen mit einem in Serie geschalteten Widerstand an einer Konstantspannungsquelle hergestellt wird.

7. Verfahren nach Anspruch 4, bei dem im Falle einer bei konstanter Lichtleistung und zunehmendem Diodenstrom linear ansteigenden Durchlassspannung dieser Zusammenhang hergestellt wird durch Betrieb der Leuchtdiode oder Laserdiode an einer geeigneten Schaltung mit negativem Widerstand, deren Referenzeingang mit einer Konstantspannungsquelle verbunden ist.

8. Verfahren zur Stabilisierung mehrerer gleichartiger Leuchtdioden oder Laserdioden, bei dem eine Leuchtdiode oder Laserdiode mit einem Verfahren nach einem der Ansprüche 3 oder 5 bis 7 stabilisiert wird, und die restlichen Leuchtdioden oder Laserdioden in Serie geschaltet so betrieben werden, dass der durch die erste Leuchtdiode oder Laserdiode fließende Strom auch durch die restlichen fließt.

9. Verfahren zur Stabilisierung mehrerer gleichartiger Leuchtdioden oder Laserdioden, bei dem eine Leuchtdiode oder Laserdiode mit einem Verfahren nach einem der Ansprüche 3 oder 5 bis 7 stabilisiert wird, und die restlichen Leuchtdioden oder Laserdioden an einer oder mehreren Spannungsquellen betrieben werden, deren Quellspannung der Durchlassspannung der ersten Leuchtdiode oder Laserdiode folgt.

**10.** Verfahren zur Stabilisierung mehrerer gleichartiger Leuchtdioden oder Laserdioden, bei dem eine Leuchtdiode oder Laserdiode mit einem Verfahren nach einem der Ansprüche 3 oder 5 bis 7 stabilisiert wird, ein erster Teil der restlichen Leuchtdioden oder Laserdioden in Serie geschaltet so betrieben werden, dass der durch die erste Leuchtdiode oder Laserdiode fließende Strom auch durch diesen ersten Teil der restlichen fließt, ein zweiter Teil der restlichen Leuchtdioden oder Laserdioden an einer oder mehreren Spannungsquellen betrieben werden, deren Quellspannung der Durchlassspannung der ersten Leuchtdiode oder Laserdiode folgt, und weitere Teile der restlichen Leuchtdioden oder Laserdioden in Serie geschaltet so betrieben werden, dass die durch die Leuchtdioden oder Laserdioden des zweiten Teils fließenden Ströme auch durch die weiteren Teile fließen.

**11.** Verfahren zur Bestimmung der Durchlassspannung einer Leuchtdiode oder Laserdiode (1) als Funktion des Diodenstroms bei konstanter Lichtleistung, bei der die Temperatur der Leuchtdiode oder Laserdiode (1) mit Hilfe einer Heiz- und Kühleinrichtung (2,3) variiert wird, wobei die ausgesandte Lichtleistung mit Hilfe eines Photodetektors (4) erfasst und mit Hilfe einer Regeleinrichtung (5,6,7) konstant gehalten wird, und die Werte von Durchlassspannung und Diodenstrom bei verschiedenen Temperaturen erfasst werden.

**12.** Verfahren zur Ermittlung der Parameter eines linearen Zusammenhangs zwischen Diodenstrom und Durchlassspannung einer Leuchtdiode oder Laserdiode bei konstanter Lichtleistung oder zum Abgleich der Beschaltung einer mit einem Verfahren nach einem der Ansprüche 5 bis 7 stabilisierten Leuchtdiode oder Laserdiode, bei dem der Zeitverlauf der Lichtleistung während eines Einschaltvorgangs verfolgt und die Parameter so eingestellt werden, dass die Lichtleistung trotz der nach dem Einschalten ansteigenden Temperatur der Leuchtdiode oder Laserdiode konstant bleibt.

**Claims**

**1.** A method for stabilizing the optical output power of light-emitting diodes and laser diodes, whereby the combination of diode current and conduction voltage serves as a definite measure of the optical power emitted by the light-emitting diode or laser diode, it being presupposed that conduction voltage is a function of diode current at constant optical power independently of temperature, whereby the function by which the conduction voltage results from the diode current at a certain constant optical power is determined by measurements of diode current and conduction voltage at constant optical power at different temperatures, and whereby the light-emitting diode or laser diode is operated for stabilization thereof in such a way that the functional relation between conduction voltage and diode current as determined by the measurement is maintained.

**2.** The method according to claim 1, wherein the light-emitting diode or laser diode is so wired that the functional relation between diode current and conduction voltage as determined by the measurement comes about solely due to electrical mechanisms without the necessity of measuring optical power or temperature during stabilization.

**3.** The method according to claim 2, wherein the conduction voltage is measured via an analog-digital interface with the help of a suitable data processing device, and the diode current is controlled via a digital-analog interface such that the previously determined functional relation results between adjusted diode current and measured conduction voltage.

**4.** The method according to claim 2, wherein it is presupposed that the function by which the conduction voltage results from the diode current at constant optical power is a linear function.

**5.** The method according to claim 4, wherein said relation is produced by operating the light-emitting diode or laser diode on a constant voltage source in the case of a conduction voltage remaining constant at constant optical power and increasing diode current.

**6.** The method according to claim 4, wherein said relation is produced by operating the light-emitting diode or laser diode together with a series-connected resistor on a constant voltage source in the case of a conduction voltage dropping linearly at constant optical power and increasing diode current.

**7.** The method according to claim 4, wherein said relation is produced by operating the light-emitting diode or laser diode on a suitable circuit with negative resistance, whose reference input is connected to a constant voltage source, in the case of a conduction voltage rising linearly at constant optical power and increasing diode current.

8. A method for stabilizing a plurality of similar light-emitting diodes or laser diodes, wherein one light-emitting diode or laser diode is stabilized with a method according to any of claims 3 or 5 to 7, and the remaining light-emitting diodes or laser diodes are so operated in series connection that the current flowing through the first light-emitting diode or laser diode also flows through the remaining ones.

9. A method for stabilizing a plurality of similar light-emitting diodes or laser diodes, wherein one light-emitting diode or laser diode is stabilized with a method according to any of claims 3 or 5 to 7, and the remaining light-emitting diodes or laser diodes are operated on one or more voltage sources whose source voltage follows the conduction voltage of the first light-emitting diode or laser diode.

10. A method for stabilizing a plurality of similar light-emitting diodes or laser diodes, wherein one light-emitting diode or laser diode is stabilized with a method according to any of claims 3 or 5 to 7, a first portion of the remaining light-emitting diodes or laser diodes are so operated in series connection that the current flowing through the first light-emitting diode or laser diode also flows through said first portion of the remaining ones, a second portion of the remaining light-emitting diodes or laser diodes are operated on one or more voltage sources whose source voltage follows the conduction voltage of the first light-emitting diode or laser diode, and further portions of the remaining light-emitting diodes or laser diodes are so operated in series connection that the currents flowing through the light-emitting diodes or laser diodes of the second portion also flow through the further portions.

11. A method for determining the conduction voltage of a light-emitting diode or laser diode (1) as a function of the diode current at constant optical power, wherein the temperature of the light-emitting diode or laser diode (1) is varied with the help of a heating and cooling device (2, 3), the emitted optical power being detected with the help of a photodetector (4) and kept constant with the help of a control device (5, 6, 7), and the values of conduction voltage and diode current are detected at different temperatures.

12. A method for determining the parameters of a linear relation between diode current and conduction voltage of a light-emitting diode or laser diode at constant optical power or for balancing the wiring of a light-emitting diode or laser diode stabilized with a method according to any of claims 5 to 7, wherein the time response of the optical power during a switch-on process is tracked and the parameters are so adjusted that the optical power remains constant despite the rising temperature of the light-emitting diode or laser diode after switch-on.

**Revendications**

1. Procédé de stabilisation du rendement de sortie optique (rendement lumineux) de diodes électroluminescentes et de diodes laser, la combinaison de courant de diode et de tension à l'état passant servant de mesure univoque pour le rendement lumineux émis par la diode électroluminescente ou par la diode laser, dans lequel on suppose qu'indépendamment de la température à un rendement lumineux constant, la tension à l'état passant est une fonction du courant de diode, dans lequel la fonction par laquelle, à un rendement lumineux constant déterminé, la tension à l'état passant résulte du courant de diode, est déterminée par des mesures de courant de diode et de tension à l'état passant et dans lequel la diode électroluminescente ou la diode laser fonctionne pour sa stabilisation de telle sorte que la relation fonctionnelle déterminée par la mesure est respectée entre la tension à l'état passant et le courant de diode.

2. Procédé selon la revendication 1, dans lequel la diode électroluminescente ou la diode laser est commutée de telle sorte que la relation fonctionnelle déterminée par la mesure entre la tension à l'état passant et le courant de diode s'établit seule en raison de mécanismes électriques sans la nécessité de mesurer le rendement lumineux ou la température pendant la stabilisation.

3. Procédé selon la revendication 2, dans lequel à l'aide d'un dispositif de traitement de données approprié, la tension à l'état passant est mesurée via une interface analogique numérique, et le courant de diode est commandé via une interface numérique analogique de telle sorte qu'il résulte entre le courant de diode établi et la tension à l'état passant mesurée la relation fonctionnelle déterminée.

4. Procédé selon la revendication 2, dans lequel il est supposé que la fonction par laquelle la tension à l'état passant résulte du courant de diode, lors d'un rendement lumineux constant, est une fonction linéaire.

5. Procédé selon la revendication 4, dans lequel, en cas d'une tension à l'état passant restant la même, à un rendement lumineux constant, et d'un courant de diode croissant, cette relation est établie par le fonctionnement de la diode électroluminescente ou de la diode de laser au niveau d'une source de tension constante.

6. Procédé selon la revendication 4, dans lequel en cas d'une tension à l'état passant, qui tombe de façon linéaire, à un rendement lumineux constant, et d'un courant de diode croissant, cette relation est établie par le fonctionnement de la diode électroluminescente ou de la diode de laser, conjointement avec une résistance montée en série, au niveau d'une source de tension constante.

7. Procédé selon la revendication 4, dans lequel en cas d'une tension à l'état passant qui augmente de façon linéaire, à un rendement lumineux constant, et d'un courant de diode croissant, cette relation est établie par le fonctionnement de la diode électroluminescente ou de la diode de laser, au niveau d'un circuit approprié avec résistance négative, dont l'entrée de référence est reliée à une source de tension constante.

8. Procédé de stabilisation de plusieurs diodes électroluminescentes ou diodes laser de même type, dans lequel une diode électroluminescente ou une diode laser est stabilisée par un procédé selon l'une des revendications 3 ou 5 à 7, et les diodes électroluminescentes ou diodes laser restantes, sont montées en série, fonctionnent de telle sorte que le courant qui passe à travers la première diode électroluminescente ou la première diode laser passe aussi à travers celles qui restent.

9. Procédé de stabilisation de plusieurs diodes électroluminescentes ou diodes laser de même type, dans lequel une diode électroluminescente ou une diode laser est stabilisée par un procédé selon l'une des revendications 3 ou 5 à 7, et les diodes électroluminescentes ou les diodes laser restantes fonctionnent sur une ou plusieurs sources de tension dont la tension de source suit la tension à l'état passant de la première diode électroluminescente ou diode laser.

10. Procédé de stabilisation de plusieurs diodes électroluminescentes ou diodes laser de même type, dans lequel une diode électroluminescente ou une diode laser est stabilisée par un procédé selon l'une des revendications 3 ou 5 à 7, une première partie des diodes électroluminescentes restantes, montées en série, fonctionne de telle sorte que le courant qui passe à travers la première diode électroluminescente ou la première diode laser passe aussi à travers cette première partie de celles qui restent, une deuxième partie des diodes électroluminescentes ou des diodes laser fonctionne au niveau d'une ou de plusieurs sources de tension dont la tension de source suit la tension à l'état de passage de la première diode électroluminescente ou de la première diode laser, et d'autres parties des diodes électroluminescentes ou diodes laser restantes, montées en série, fonctionnent de telle sorte que les courants qui passent à travers les diodes électroluminescentes ou les diodes laser de la deuxième partie passent aussi à travers les autres parties.

11. Procédé pour déterminer la tension à l'état passant d'une diode électroluminescente ou d'une diode laser (1) en tant que fonction du courant de diode à un rendement lumineux constant, dans lequel la température de la diode électroluminescente ou de la diode laser (1) est variée à l'aide d'un dispositif de chauffage et de refroidissement (2, 3), le rendement lumineux émis étant détecté à l'aide d'un photodétecteur (4) et maintenu constant à l'aide d'un dispositif de régulation (5, 6, 7), et dans lequel les valeurs de la tension à l'état passant et le courant de diode sont détectées à différentes températures.

12. Procédé pour déterminer les paramètres d'une relation linéaire entre le courant de diode et la tension à l'état passant d'une diode électroluminescente ou d'une diode laser à un rendement lumineux constant ou pour régler la mise en circuit d'une diode électroluminescente ou d'une diode laser stabilisée par un procédé selon l'une des revendications 5 à 7, dans lequel le cours du temps poursuit le rendement lumineux pendant une opération de mise en circuit et les paramètres sont établis de telle sorte que le rendement lumineux reste constant malgré la température montante de la diode électroluminescente ou de la diode laser après la mise en circuit.

Fig. 1

Fig. 2

Fig. 3

Fig. 4

Fig. 5

Fig. 6

Fig. 7

**Fig. 8**

**Fig. 9**

+Ub o——[ R1 ]——— IC1
Vin    Vout
ADJ

R2    R3        R5    R6

R4                    LED1

# Fig. 10

+Ub                      +Ub
o                        o

R1                       R2

OP1
+              R3
—                    T1

R4              P2
                        LED1
P1

R5

# Fig. 11

# Fig. 12

# Fig. 13

# Fig. 14

# Fig. 15

Fig. 16